(19) Europäisches Patentamt

European Patent Office

Office européen des brevets

(11) Veröffentlichungsnummer: **0 299 216 B1**

(12) **EUROPÄISCHE PATENTSCHRIFT**

(45) Veröffentlichungstag der Patentschrift: **25.03.92**

(21) Anmeldenummer: **88109473.4**

(22) Anmeldetag: **14.06.88**

(51) Int. Cl.⁵: **H05K 13/04**, H01L 21/00, B65G 27/34

(54) **Einrichtung zum Speichern, Vereinzeln und Zuführen von als Schüttgut aufnehmbaren Teilen.**

(30) Priorität: **17.07.87 DE 3723731**

(43) Veröffentlichungstag der Anmeldung:
**18.01.89 Patentblatt 89/03**

(45) Bekanntmachung des Hinweises auf die Patenterteilung:
**25.03.92 Patentblatt 92/13**

(84) Benannte Vertragsstaaten:
**CH DE FR IT LI**

(56) Entgegenhaltungen:
**EP-A- 0 016 368**

**PATENT ABSTRACTS OF JAPAN, Band 8, Nr. 136 (M-304)[1573], 23. Juni 1984, Seite 116 M 304; & JP-A-59 36 012**

(73) Patentinhaber: **SIEMENS AKTIENGESELL-SCHAFT**
**Wittelsbacherplatz 2**
**W-8000 München 2(DE)**

(72) Erfinder: **Blanchard, Jean-C.**
**Gurzelenstrasse 12**
**CH-4512 Bellach(CH)**

**Beschreibung**

Die Erfindung betrifft eine Einrichtung zum Speichern, Vereinzeln und Zuführen von als Schüttgut aufnehmbaren Teilen, insbesondere von SMD-Bauelementen, mit
- einem Vorratsbehälter zur Aufnahme des Schüttguts,
- zwei parallel nebeneinander angeordneten Längsförderern mit entgegengesetzten Förderrichtungen zur Erzeugung eines rechteckförmigen Umlaufs der Teile im Vorratsbehälter und
- einer Maske, durch welche die im Vorratsbehälter umlaufenden Teile nacheinander und lagegerecht über eine Förderschiene einer Entnahmeposition eines der beiden Längsförderer zuführbar sind.

Eine solche Einrichtung ist aus EP-A-0016368 bekannt.

Der Wunsch nach der Verkleinerung von Leiterplatten führte dazu, daß die Oberflächenmontage von Bauelementen, wie sie schon bei Schichtschaltungen seit langem üblich ist, nun auch zunehmend bei Leiterplatten zur Anwendung kommt.

Dabei werden die oberflächenlötbaren Bauelemente, die entsprechend dem englischsprachigen Begriff "Surface Mounted Devices" auch kurz SMD-Bauelemente genannt werden, nicht mehr in die Löcher der Platinen gesteckt, sondern auf deren Oberfläche aufgelötet. Sie benötigen 30 % bis 60 % weniger Platz. Da sich natürlich auch die Zahl der Durchkontaktierungen verringert, kann insgesamt mit einer Kostenreduzierung im Bereich von etwa 50 % gerechnet werden.

Für die automatische Bestückung von Leiterplatten oder Keramiksubstraten mit SMD-Bauelementen wie Widerständen, Kondensatoren, Dioden, Transistoren und dergleichen werden Bestückautomaten eingesetzt, die nach dem sogenannten Pick & Place Prinzip arbeiten. Die Zuführung der Bauelemente richtet sich dabei nach ihrem Anlieferungszustand. Sowohl für Schüttgut, wie auch für Magazine, Vorratsbänder etc. stehen Zuführmodule zur Verfügung, wobei insbesondere Vibrationsrundförderer-Module für Schüttgut, Vibrationslängsförderer-Module für Stangenmagazine und Gurt-Zuführmodule eingesetzt werden. Über diesen Zuführmodulen und der im Bestückbereich ortsfest zentrierten Leiterplatte oder einem im Bestückbereich ortsfest zentrierten Keramiksubstrat bewegt sich ein Bestückkopf, der an eine freiprogrammierbare Positioniereinheit mit zwei Freiheitsgraden angeflanscht ist. Der zur Aufnahme der Bauelemente mit einer Saugpipette und zum Zentrieren der aufgenommenen Bauelemente mit zwei Zangenpaaren ausgerüstete Bestückkopf enthält weitere drei freiprogrammierbare Achsen für die Funktionen Heben und Senken der Saugpipette, Zentrieren der Bauelemente und Drehen der Bauelemente. Der Bestückkopf nimmt die Bauelemente aus den Spuren der Zuführmodule an den jeweiligen Entnahmepositionen mit Hilfe der Saugpipette auf, worauf das jeweils aufgenommene Bauelement mit Hilfe der beiden Zangenpaare in zwei Achsrichtungen zentriert, in die Einbaulage gedreht und in der vorgesehenen Bestückposition auf der Leiterplatte oder dem Keramiksubstrat abgesetzt wird. Anschließend werden die derart bestückten Substrate zum Reflow-Löten weitergegeben, wobei die Oberflächenmontage der Bauelemente insbesondere duch die Dampfphasenlötung (Vapor phase soldering) abgeschlossen wird.

In der US-PS 4 135 630 ist ein Bestückautomat beschrieben, der nach dem Pick & Place Prinzip arbeitet und einen mit Saugpipette und zwei Zangenpaaren zum Zentrieren der aufgenommenen Bauelemente ausgerüsteten Bestückkopf besitzt.

Bei der automatischen Bestückung von Leiterplatten oder Keramiksubstraten mit SMD-Bauelementen wie Widerständen, Kondensatoren, Dioden, Transistoren, Chips und dergleichen werden häufig aus stranggepreßten Profilen bestehende Förderschienen nebeneinander auf dem Rütteltisch eines Vibrationslängsförderers angeordnet. Die am hinteren Ende der Förderschienen in Vorratsbehältern als Schüttgut gespeicherten elektronischen Bauelemente werden durch die Schwingbewegungen das Längsförderers zum vorderen Ende der Förderschienen hin befördert, an welchem durch eine Abflachung bzw. Ausfräsung eine Entnahmeposition für die Bauelemente gebildet ist. Die Entnahme der in diesen Entnahmepositionen bereitgestellten Bauelemente erfolgt dann jeweils bei Stillstand des Längsförderers über den Bestückkopf, welcher das Bauteil mit der Saugpipette erfaßt und auf einer vorbestimmten Stelle der Leiterplatte oder des Keramiksubstrats ablegt. Da von den Bestückautomaten eine Bestückungssicherheit von 99,99 % gefordert wird, muß der auf die Entnahmeposition der Längsförderer programmierte Bestückkopf die Bauelemente dort auch stets in der richtigen Lage antreffen. Für diese richtige Lage der Bauelemente sorgen im Anfangsbereich der Förderbahn des Vibrationslängsförderers angeordnete Masken, die als Sperre für falsch liegende Bauelemente wirken und die Bauelemente nur einzeln durchlassen. Der Durchtrittsquerschnitt dieser Masken ist also derart auf die Form und Größe der Bauelemente abgestimmt, daß diese nur in der richtigen Lage und nacheinander hindurchtreten und zur Entnahmeposition transportiert werden können.

Bei der vorstehend beschriebenen Einrichtung zum Speichern, Vereinzeln und Zuführen von als Schüttgut aufnehmbaren SMD-Bauelementen kann es in Förderrichtung gesehen vor der Maske zu einem Stau falsch liegender Bauelemente kommen, wobei ein derartiger Stau bereits durch ein einziges Bauelement aufgelöst werden kann, welches den Durchtrittsquerschnitt der Maske blockiert. Zur Vermeidung eines derartigen Staus wird bei der Einrichtung der eingangs genannten Art ein rechteckförmiger Umlauf der Bauelemente im Vorratsbehälter erzeugt. Hierdurch werden einerseits falsch liegende Bauelemente weitertransportiert und andererseits stets neue Bauelemente an die Maske herangeführt. Zur Erzeugung des rechteckförmigen Umlaufs der Bauelemente wird parallel neben dem eigentlichen Längsförderer ein zweiter Längsförderer angeordnet, welcher die nicht durch die Maske hindurchtretenden Bauelemente innerhalb des Vorratsbehälters in dessen rückwertigen Bereich transportiert. Abgesehen von dem zusätzlichen baulichen Aufwand ergibt sich durch die Anordnung von zwei Längsförderern mit zwei elektromagnetischen Schwingantrieben auch ein erhöhter Platzbedarf. Bei der automatischen Bestückung von Leiterplatten oder Keramiksubstraten mit SMD-Bauelementen nach dem Pick & Place Prinzip wird jedoch eine möglichst hohe Bauelemente-Bereitstellkapazität angestrebt, um ein möglichst breites Fertigungsspektrum abzudecken, den Umrüstaufwand zu minimieren und die software-bedingte Flexibilität der Automaten optimal zu nutzen. Diese hohe Bauelemente-Bereitstellkapazität erfordert möglichst viele Bauelemente-Spuren im Zugriffsbereich des Bestückkopfes.

Der Erfindung liegt die Aufgabe zugrunde bei Einrichtungen zum Speichern, Vereinzeln und Zuführen von als Schüttgut aufnehmbaren Bauelementen eine höhere Anordnungsdichte der Bauelemente-Spuren zu ermöglichen.

Diese Aufgabe wird erfindungsgemäß dadurch gelöst, daß durch jeweils in Förderrichtung nacheinander angeordnete Förderbahnabschnitte der beiden Längsförderer mindestens zwei Vorratsbehälter mit jeweils rechteckförmigen Umlauf der Teile gebildet sind und daß jedem Vorratsbehälter eine Maske und eine zu einer separaten Entnahmeposition führende Förderschiene zugeordnet sind.

Bei der neuen Einrichtung ist also einer Zwei- oder Mehrfachanordnung der Vorratsbehälter mit separaten Bauelemente-Spuren und separaten Entnahmepositionen vorgesehen. Auf diese Weise können bei äußerst geringem Platzbedarf und mit einem geringen baulichen Aufwand pro Einrichtung zwei oder mehrere Arten von Bauelementen bereitgestellt werden. Somit ergibt sich eine Erhöhung der Bauelemente-Bereitstellkapazität bzw. der Vielfalt der Bauelemente.

Gemäß einer bevorzugten Ausgestaltung der Erfindung sind die Förderschienen unmittelbar nebeneinander auf dem zugeordneten Längsförderer angeordnet. Durch diese Maßnahmen kann die Baubreite der gesamten Einrichtung noch weiter reduziert werden.

Eine weitere Verringerung des Platzbedarfs kann auch dadurch erzielt werden, daß elektromagnetische Schwingantriebe der beiden Längsförderer durch einen gemeinsamen, feststehenden Elektromagneten und separate, unmittelbar nebeneinander angeordnete und jeweils fest mit der zugeordneten Förderbahn verbundene Anker gebildet sind. Neben dem geringeren Platzbedarf ergibt sich durch diese Vereinfachung der Schwingantriebe auch eine erhebliche Reduzierung des baulichen Aufwands.

Vorzugsweise ist der Elektromagnet auf einem gemeinsamen Grundrahmen der beiden Längsförderer angeordnet. Hierdurch kann eine besonders gedrängte Bauweise realisiert werden.

Sind die dem Elektromagneten zugewandten Flächen der beiden Anker senkrecht oder schräg zu den Förderrichtungen der beiden Längsförderer ausgerichtet, so ergibt sich im Hinblick auf den maßgeblichen ersten Längsförderer eine Förderung nach dem Wurfprinzip mit einem besonders stabilen Förderverhalten.

Eine besonders einfach aufgebaute und kompakt ausgebildete Abstützung der Förderbahnen kann dadurch erzielt werden, daß jeweils schräg entgegen der Förderrichtung angeordnete Lenkerblattfedern der beiden Längsförderer fest mit dem Grundrahmen verbunden sind.

Ein Ausführungsbeispiel der Erfindung ist in der Zeichnung dargestellt und wird im folgenden näher beschrieben.

Es zeigen

Fig. 1    eine perspektivische Darstellung einer Einrichtung zum Speichern, Vereinzeln und Zuführen von als Schüttgut aufnehmbaren SMD-Bauelementen und

Fig. 2    eine Draufsicht auf die Einrichtung gemäß Fig. 1.

Die Zeichnung zeigt in stark vereinfachter schematischer Darstellung eine Einrichtung zum Speichern, Vereinzeln und Zuführen von nicht näher dargestellten SMD-Bauelementen, die in insgesamt drei Vorratsbehältern Vb1, Vb2 und Vb3 als Schüttgut aufgegeben werden. Die Einrichtung umfaßt zwei parallel nebeneinander angeordnete Längsförderer Lf1 und Lf2, deren durch Pfeile Fr1 und Fr2 angedeutete Förderrichtungen einander entgegengesetzt sind. Die Vorratsbehälter Vb1, Vb2 und Vb3 sind dabei durch jeweils in Förderrichtung Fr1 bzw. Fr2 nacheinander angeordnete Förderbahnabschnitte der beiden Längsförderer Lf1 und Lf2 gebildet, so daß sich in jedem Behälter ein rechteckförmiger Umlauf der SMD-Bauelemente ergibt.

Die im ersten Vorratsbehälter Vb1 angeordneten SMD-Bauelemente werden im Bereich des zum ersten Längsförderer Lf1 gehörenden Förderbahnabschnittes in der Förderrichtung Fr1 zu einer Maske M1 hin transportiert. Bei dieser Maske M1 handelt es sich um eine Sperre oder Ordnungshilfe, deren Durchtrittsquerschnitt so auf die Form und Größe der jeweiligen SMD-Bauelemente abgestimmt ist, daß diese nur in der richtigen Lage und nacheinander hindurchtreten können. Die durch die Maske M1 vereinzelten und lagegerecht orientierten SMD-Bauelemente werden dann in Förderrichtung Fr1 über eine auf dem ersten Längsförderer Lf1 angeordnete Förderschiene Fs1 zu einer am vorderen Ende dieser Förderschiene Fs1 gebildeten Entnahmeposition Ep1 weiterbefördert und dort in der richtigen Lage vom Bestückkopf eines Bestückautomaten abgeholt.

Die von der Maske M1 aufgrund ihrer falschen Lage abgewiesenen SMD-Bauelemente rutschen über eine schräg geneigte Fläche Fl1 des ersten Längsförderers Lf1 quer zur Förderrichtung Fr1 in Richtung des zweiten Pfeiles Q1 auf den zugeordneten Förderbahnabschnitts des zweiten Längsförderes Lf2, auf welchen sie in der entgegengesetzten Förderrichtung Fr2 zurücktransportiert werden. Dieser Förderbahnabschnitt steigt dabei in Förderrichtung Fr2 gesehen etwas an, so daß die SMD-Bauelemente zur Schließung des rechteckförmigen Umlaufs am Ende des Vorratsbehälters Vb1 in Querrichtung Q2 schräg nach unten auf den zugeordneten Förderbahnabschnitt des ersten Längsförderers Lf1 rutschen können. Als Leiteinrichtung für den rechteckförmigen Umlauf der SMD-Bauelemente dient eine im mittleren Bereich des Vorratsbehälters Vb1 angeordnete und in Förderrichtung Fr1 bzw. Fr2 ausgerichtete Trennwand Tw1, die in dargestellten Ausführungsbeispiel auf der Oberseite des zweiten Längsförderers Lf2 befestigt ist.

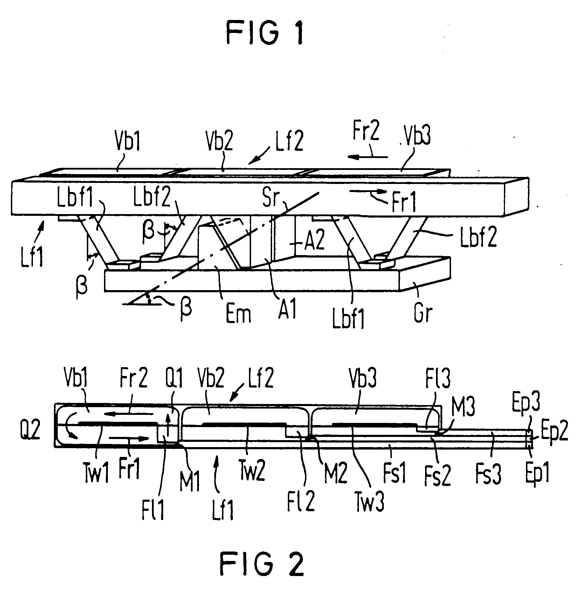

Das am Beispiel des ersten Vorratsbehälters Vb1 geschilderte Umlauf- und Vereinzelungsprinzip gilt auch in entsprechender Weise für den zweiten Vorratsbehälter Vb2 und den dritten Vorratsbehälter Vb3, wobei hier die Maske mit M2 bzw. M3, die Förderschiene mit Fs2 bzw. Fs3, die Entnahmeposition mit Ep2 bzw. Ep3, die schräg geneigte Fläche mit Fl2 bzw. Fl3 und die Trennwand mit Tw2 bzw. Tw3 bezeichnet sind. Insbesondere aus der in Fig. 2 dargestellten Draufsicht ist zu erkennen, daß mit den unmittelbar hintereinander geordneten Vorratsbehälter Vb1, Vb2 und Vb3 auf engstem Raum mit einem Minimum an baulichem Aufwand drei verschiedene Arten von SMD-Bauelementen an den entsprechenden Entnahmepositionen Ep1, Ep2 und Ep3 bereitgestellt werden können.

Die vorstehende beschriebene Kompaktanordnung mit drei Vorratsbehältern Vb1, Vb2 und Vb3 und drei Bauelemente-Spuren steht im engen Zusammenhang mit der Vereinfachung und raumsparenden Ausgestaltung der Schwingantriebe der beiden Längsförderer Lf1 und Lf2. Fig. 1 zeigt, daß die beiden Längsförderer Lf1 und Lf2 über schräg gestellte Lenkerblattfedern Lbf1 und Lbf2 elastisch auf einem gemeinsamen Grundrahmen Gr abgestützt sind. Die beidseitig fest eingespannten Lenkerblattfedern Lbf1 und Lbf2 dienen hierbei als potentielle Energiespeicher. Die Lenkerblattfedern Lbf1 des ersten Längsförderers Lf1 sind hierbei schräg gegen die Förderrichtung Fr1 geneigt, während die Lenkerblattfedern Lbf2 des zweiten Längsförderers Lf2 schräg gegen dessen Förderrichtung Fr2 geneigt sind. Die Anstellwinkel $\beta$ der Lenkerblattfedern Lbf1 und Lbf2 gegen die vertikale Richtung sind hierbei jeweils gleich groß und betragen im dargestellten Ausführungsbeispiel bis 30°. Die unmittelbar nebeneinander angeordneten Anker A1 und A2 der beiden Längsförderer Lf1 und Lf2 sind einem gemeinsamen Elektromagneten Em zugeordnet, welcher auf dem gemeinsamen Grundrahmen Gr befestigt ist. Die dem Elektromagneten Em zugewandten Flächen der auf den Unterseiten der zugeordneten Förderbahnen befestigten Anker A1 und A2 sowie die wirksame Fläche des Elektromagneten Em sind derart schräg ausgerichtet, daß sich eine senkrecht zu den Lenkerblattfedern Lbf1 verlaufende Schwingrichtung Sr ergibt. Dementsprechend ist die Schwingrichtung Sr zur horizontalen Richtung um den Winkel $\beta$ geneigt.

Mit der senkrecht zu den Lenkerblattfedern Lbf1 ausgerichteten Schwingrichtung Sr ergibt sich für den ersten Längsförderer Lf1, der ja auch den Transport der SMD-Bauelemente zu den Entnahmepositionen Ep1, Ep2 und Ep3 übernimmt ein äußerst stabiles Förderverhalten ohne merklichen Einfluß der jeweiligen Masse des Fördergutes. Im Hinblick auf das Förderverhalten des zweiten Längsförderers Lf2 läßt sich mit der genannten Schwingrichtung Sr ein Förderverhalten realisieren, das für die Erzeugung eines geschlossenen Umlaufs der SMD-Bauelemente in den jeweiligen Vorratsbehältern Vb1, Vb2 und Vb3 vollständig ausreicht. Da das Schwingungsverhalten des zweiten Längsförderers Lf2 in erster Linie durch die Art und Anordnung der Lenkerblattfedern Lbf2 bestimmt wird, muß lediglich der Fall ausgeschlossen werden, daß die Schwingungsrichtung Sr parallel zu der Lenkerblattfeder Lbf2 verläuft. Im übrigen kann das Förderverhalten beider Längsförderer Lf1 und Lf2 durch Einstellung der Spaltbreiten zwischen den gemeinsamen Elektromagneten Em und den Ankern A1 bzw. A2 variiert werden.

Die Förderschienen Fs1 bis Fs2 können auf dem Längsförderer Lf1 beispielsweise durch Magnetkraft gehalten werden, wodurch ein schnelles müheloses und verschleißfreies Austauschen erreicht wird. Weitere Einzelheiten über eine derartige magnetische Halterung gehen aus der DE-A-31 24 846 hervor. Damit sich die SMD-Bauelemente im Bereich der Entnahmepositionen Ep1 bis Ep3 mit Sicherheit nicht aufstellen können, können dort bewegliche Abdeckungen angebracht werden, welche die Entnahmeöffnung während des Betriebes des Längsförderers Lf1 verschließen und beim Stillstand des Längsförderers Lf1 geöffnet werden. Nähere Einzelheiten hierzu gehen aus der DE-A-33 05 738 hervor.

Bei dem vorstehend beschriebenen Ausführungsbeispiel sind durch drei Förderbahnabschnitte drei Vorratsbehälter mit drei Zuführspuren gebildet. Anordnungen mit mehr als drei Förderbahnabschnitten, Vorratsbehältern und Zuführspuren sind jedoch ebenfalls möglich, wobei sich in diesem Fall dann eine entsprechende Vergrößerung der Gesamtbreite der Anordnung ergibt.

**Patentansprüche**

1. Einrichtung zum Speichern, Vereinzeln und Zuführen von als Schüttgut aufnehmbaren Teilen, insbesondere von SMD-Bauelementen mit
   - einem Vorratsbehälter (Vb1) zur Aufnahme des Schüttguts,
   - zwei parallel nebeneinander angeordneten Längsförderern (Lf1,Lf2) mit entgegengesetzten Förderrichtungen (Fr1,Fr2) zur Erzeugung eines rechteckförmigen Umlaufs der Teile im Vorratsbehälter (Vb1) und
   - einer Maske (M1), durch welche die im Vorratsbehälter (Vb1) umlaufenden Teile nacheinander und lagegerecht über eine Förderschiene (Fs1) einer Entnahmeposition (Ep1) eines der beiden Längsförderer (Lf1) zuführbar sind,
   **dadurch gekennzeichnet,**
   daß durch jeweils in Förderrichtung (Fr1,Fr2) nacheinander angeordnete Förderbahnabschnitte der beiden Längsförderer (Lf1,Lf2) mindestens zwei Vorratsbehälter (Vb1,Vb2,Vb3) mit jeweils rechteckförmigem Umlauf der Teile gebildet sind und daß jedem Vorratsbehälter (Vb1,Vb2,Vb3) eine Maske (M1,M2,M3) und eine zu einer separaten Entnahmeposition (Ep1,Ep2,Ep3) führende Förderschiene (Fs1,Fs2,Fs3) zugeordnet sind.

2. Einrichtung nach Anspruch 1,
   **dadurch gekennzeichnet,**
   daß die Förderschienen (Fs1,Fs2,Fs3) unmittelbar nebeneinander auf dem zugeordneten Längsförderer (Lf1) angeordnet sind.

3. Einrichtung nach Anspruch 1 oder 2,
   **dadurch gekennzeichnet,**
   daß elektromagnetische Schwingantriebe der beiden Längsförderer (Lf1,Lf2) durch einen gemeinsamen, feststehenden Elektromagneten (Em) und separate, unmittelbar nebeneinander angeordnete und jeweils fest mit der zugeordneten Förderbahn verbundene Anker (A1,A2) gebildet sind.

4. Einrichtung nach Anspruch 3,
   **dadurch gekennzeichnet,**
   daß der Elektromagnet (Em) auf einem gemeinsamen Grundrahmen (Gr) der beiden Längsförderer (Lf1,Lf2) angeordnet ist.

5. Einrichtung nach Anspruch 3 oder 4,
   **dadurch gekennzeichnet,**
   daß die dem Elektromagneten (Em) zugewandten Flächen der beiden Anker (A1,A2) senkrecht oder schräg zu den Förderrichtungen (Fr1,Fr2) der beiden Längsförderer (Lf1,Lf2) ausgerichtet sind.

6. Einrichtung nach Anspruch 4 oder 5,
   **dadurch gekennzeichnet,**
   daß jeweils schräg entgegen der Förderrichtung (Fr1,Fr2) geneigte Lenkerblattfedern (Lbf1,Lbf2) der beiden Längsförderer (Lf1,Lf2), fest mit dem Grundrahmen (Gr) verbunden sind.

**Claims**

1. Device for storing, isolating and feeding components, in particular surface-mounted devices, which can be loaded as bulk material, having
   - a storage container (Vb1) for receiving the bulk material,
   - two longitudinal conveyors (Lf1, Lf2) arranged in parallel next to one another and having opposite conveying directions (Fr1, Fr2) for producing a rectangular-shaped circulation of the parts in the storage container (Vb1) and
   - a mask (M1) by means of which the parts circulating in the storage container (Vb1) can be fed successively and with correct positioning via a conveying rail (Fs1) to a removal position (Ep1) of one of the two longitudinal conveyors (Lf1), characterised in that in each case two storage containers (Vb1, Vb2, Vb3) each having rectangular-shaped circulation of the parts are formed by means of conveying path sections, arranged in each case one after the other in the conveying direction (Fr1, Fr2), of the two longitudinal conveyors (Lf1, Lf2), and in that each storage container (Vb1, Vb2, Vb3) is assigned a mask (M1, M2, M3) and a conveying rail (Fs1, Fs2, Fs3) leading to a separate removal position (Ep1, Ep2, Ep3).

2. Device according to Claim 1, characterised in that the conveying rails (Fs1, Fs2, Fs3) are arranged directly next to one another on the assigned longitudinal conveyor (Lf1).

3. Device according to Claim 1 or 2, characterised in that electromagnetic vibration drives of the two longitudinal conveyors (Lf1, Lf2) are formed by means of a common, fixed electromagnet (Em) and separate armatures (A1, A2) arranged directly next to one another and in each case connected permanently to the assigned conveying path.

4. Device according to Claim 3, characterised in that the electromagnet (Em) is arranged on a common base frame (Gr) of the two longitudinal conveyors (Lf1, Lf2).

5. Device according to Claim 3 or 4, characterised in that the faces, facing the electromagnet (Em), of the two armatures (A1, A2) are aligned perpendicularly or obliquely with respect to the conveying directions (Fr1, Fr2) of the two longitudinal conveyors (Lf1, Lf2).

6. Device according to Claim 4 or 5, characterised in that connecting rod leaf springs (Lbf1, Lbf2) of the two longitudinal conveyors (Lf1, Lf2) are connected permanently to the base frame (Gr), the said leaf springs being inclined in each case obliquely counter to the conveying direction (Fr1, Fr2).

**Revendications**

1. Dispositif pour emmagasiner, individualiser et amener des pièces que l'on peut recevoir en vrac, notamment des composants montés en surface, comprenant :
   - un réservoir (Vb1) de réception des pièces en vrac,
   - deux convoyeurs longitudinaux (Lf1,Lf2) qui sont disposés parallèlement l'un à côté de l'autre et qui ont des sens de transport opposés pour produire une circulation rectangulaire des pièces dans le réservoir (Vb1) et
   - un masque (M1) à travers lequel les pièces circulant dans le réservoir (Vb1) peuvent être amenées l'une après l'autre et en position correcte et par l'intermédiaire d'un rail de convoyage (Fs1) à un poste de prélèvement (Ep1) de l'un des deux convoyeurs longitudinaux (Lf1),
   caractérisé

en ce que, par des tronçons de voie de convoyage, disposés l'un après l'autre dans le sens du transport (Fr1, Fr2), des deux convoyeurs longitudinaux (Lf1, Lf2), il est formé au moins deux réservoirs (Vb1, Vb2, Vb3) à circulation rectangulaire des pièces et en ce que, à chaque réservoir (Vb1, Vb2, Vb3) est associé un masque (M1, M2, M3) et un rail de convoyage (Fs1, Fs2, Fs3) menant à un poste de prélèvement (Ep1, Ep2, Ep3) distinct.

2. Dispositif suivant la revendication 1, caractérisé
en ce que les rails de convoyage (Fs1,Fs2,Fs3) sont disposés directement les uns à côté des autres sur le convoyeur longitudinal (Lf1) associé.

3. Dispositif suivant la revendication 1 ou 2, caractérisé
en ce que des dispositifs électromagnétiques de mise en oscillation des deux convoyeurs longitudinaux (Lf1,Lf2) sont formés par un électroaimant (Em) fixe commun et par des armatures (A1,A2) distinctes, disposées directement les uns à côté des autres et reliées rigidement à la voie de convoyage associée.

4. Dispositif suivant la revendication 3 caractérisé
en ce que l'électroaimant (Em) est disposé sur un socle (Gr) commun des deux convoyeurs longitudinaux (Lf1, Lf2).

5. Dispositif suivant la revendication 3 ou 4, caractérisé
en ce que les surfaces des deux armatures (A1,A2), tournées vers l'électroaimant (Em) sont dirigées perpendiculairement au sens de transport (Fr1,Fr2) des deux convoyeurs longitudinaux (Lf1,Lf2) ou en étant inclinés par rapport à ceux-ci.

6. Dispositif selon la revendication 4 ou 5, caractérisé
en ce que des ressorts à lames de guidage (Lbf1,Lbf2) des deux convoyeurs longitudinaux (Lf1,Lf2), qui sont inclinés par rapport au sens de transport (Fr1,Fr2), sont reliés rigidement au socle (Gr).

# FIG 1

# FIG 2